# EUROPEAN PATENT SPECIFICATION

(11) **EP 0 470 687 B1**
(45) Date of publication and mention of the grant of the patent: **06.05.1998**
(21) Application number: 91302259.6
(22) Date of filing: 15.03.1991
(51) Int. Cl.: G11B 5/39, G11B 5/02

(54) **Magneto-resistive sensor**
Magnetoresistiver Sensor
Détecteur magnétorésistif

(30) Priority: 07.08.1990 US 563990
(43) Date of publication of application: 12.02.1992
(73) Proprietor: SEAGATE TECHNOLOGY INTERNATIONAL, Georgetown Grand Cayman Island (KY)
(72) Inventor: Mowry, Gregory Stephen, Burnsville, Minnesota 55337 (US)
(74) Representative: Kenyon, Sarah Elizabeth

(56) References cited:
- EP-A- 0 037 966
- EP-A- 0 215 270
- FR-A- 2 308 159
- US-A- 4 535 375
- PATENT ABSTRACTS OF JAPAN vol. 9, no. 48 (P-338)(1771) 28 February 1985

## Description

This invention relates to magneto-resistive sensors.

Magneto-resistive sensors are used in magnetic storage systems to detect magnetically encoded information. A changing magnetic field modulates the resistivity of the magneto-resistive sensor. The resulting change in resistance is detected by passing a sense current through the magneto-resistive sensor and measuring the voltage drop across the magneto-resistive sensor. The resulting voltage signal can be used to recover information from a magnetic storage medium such as a magnetic disk.

Practical magneto-resistive sensors are typically formed using ferro-magnetic metal alloys, for example, nickel iron (Ni₈₀Fe₂₀). The nickel iron alloy is deposited in a thin film upon a substrate or wafer. Changing magnetic fields in a magnetic storage medium produce changes in the magnetisation of the magneto-resistive sensor and thereby change the resistance of the sensor. Use of a magneto-resistive head in this way for reading data recorded in a magnetic medium is disclosed in EP-A1-0 215 270.

As many as four electrical connections to the magneto-resistive sensor are needed to use the head read back stored information. Two connections are used to supply electrical current through the sensor, and two other connections are used to detect changes in voltage across an active region of the head due to the change in resistance associated with the presence of a magnetic field near the magneto-resistive sensor. Detection circuitry is connected to the magneto-resistive sensor so that the changing resistance of the magneto-resistive sensor can be monitored to produce an output which is representative of information stored on the magnetic storage medium.

The over-riding goal of all magneto-resistive sensor designs is to develop a device which is free from Barkhausen noise. This is achieved using the "hammer head" design described in US-A-4,535,375 (the preamble of claim 1 is based on this document) which uses a tapped "barber pole" array.

The barber pole array develops a longitudinal magnetic field to stabilise a central single domain region and thereby eliminate the possibility of signal degradation due to Barkhausen noise. This structure provides reproducible, stable magneto-resistive sensors. Four electrical connections are needed to operate a magneto-resistive sensor using the "hammer head" design. Additionally, an integrated inductive write/magnetoresistive read head requires at least two additional leads for a write coil. Therefore, an integrated inductive write/magneto-resistive read head using the "hammer head" design requires a minimum of six electrical connections.

A magneto-resistive head which requires fewer connections to the magneto-resistive element, while maintaining the single domain integrity of the sensor, would improve reliability, decrease manufacturing costs and be a significant contribution to the art of magneto-resistive heads.

The present invention seeks to provide a magneto-resistive sensor designed to eliminate Barkhausen noise by stabilising a single domain magnetisation state in the active region of the magneto-resistive element and which uses only two electrical connections to the magneto-resistive element.

According to the present invention there is provided a magneto-resistive sensor comprising: an elongated magneto-resistive element having an active region for sensing information stored upon a magnetic storage medium and having a first wing region; first and second terminals applied to opposite ends of the magneto-resistive element; characterised by first means connected to the magneto-resistive element for electrically shorting out AC signals generated by the first wing region of the magneto-resistive element.

A magneto-resistive sensor preferably includes a plurality of electrically conductive strips applied to the magneto-resistive element and spaced between the first and second ends.

The said first means may be a capacitor connected between a first conductive strip and the first terminal.

In one embodiment the magneto-resistive element has a second wing region, the active region being disposed between the first and second wing regions, and by second means connected to the magneto-resistive element for electrically shorting out AC signals generated by the second wing region of the magneto-resistive element. Said second means may be a capacitor connected between the second conductive strip and the second terminal, the second conductive strip being further spaced from the first end of the magneto-resistive element than the first conductive strip.

The present invention provides a magneto-resistive sensor needing only two electrical connections without sacrifice of the stability or reproducibility in the magnetic domain pattern of the magneto-resistive sensor. In the present invention, a sense current is provided to terminals on ends of the magneto-resistive sensor. Voltage sense terminals are connected to an active region of the magneto-resistive element. The voltage sense terminals are located between the end terminals. Blocking or isolation capacitors are provided between the end terminals and the voltage sense terminals which are positioned between the end terminals. In the present invention, adjacent tracks which underlie wing regions of the extended magneto-resistive sensor will not contribute a coherent noise signal to the on track signal which would render the configuration useless. The isolation capacitors allow the sense current to be applied throughout the entire barber pole array so that the stabilising effect of the barber pole array is not lost. In the present invention, off track performance is provided along with a highly stable design.

Using isolation capacitors in accordance with the present invention, a DC sense current is applied throughout the entire length of the barber pole array. Furthermore the capacitors do not alter the longitudinal stability field generated by the barber pole array. A data signal for magnetically stored information, however, is an AC signal which is not locked by the isolation capacitors. Thus, the terminals of a magneto-resistive sensor made in accordance with the present invention, carry both the DC sense current and an AC data signal. A larger valued capacitor provides smaller attenuation to the AC data signal. The present invention provides the benefits of a four terminal magneto-resistive sensor design and uses only two pairs of terminals.

The invention is illustrated, merely by way of example, in the accompanying drawings, in which:-
Figure 1 is a top plan view of a support arm and a magnetic storage disk;
Figure 2 is a perspective view of a flexure arm and slider;
Figure 3 is a perspective view of the slider of Figure 2;
Figure 4 is a perspective view of magneto-resistive heads mounted on the slider of Figure 3;
Figure 5 shows a first embodiment of a magneto-resistive sensor according to the present invention; and
Figure 6 shows a second embodiment of a magneto-resistive sensor according to the present invention.

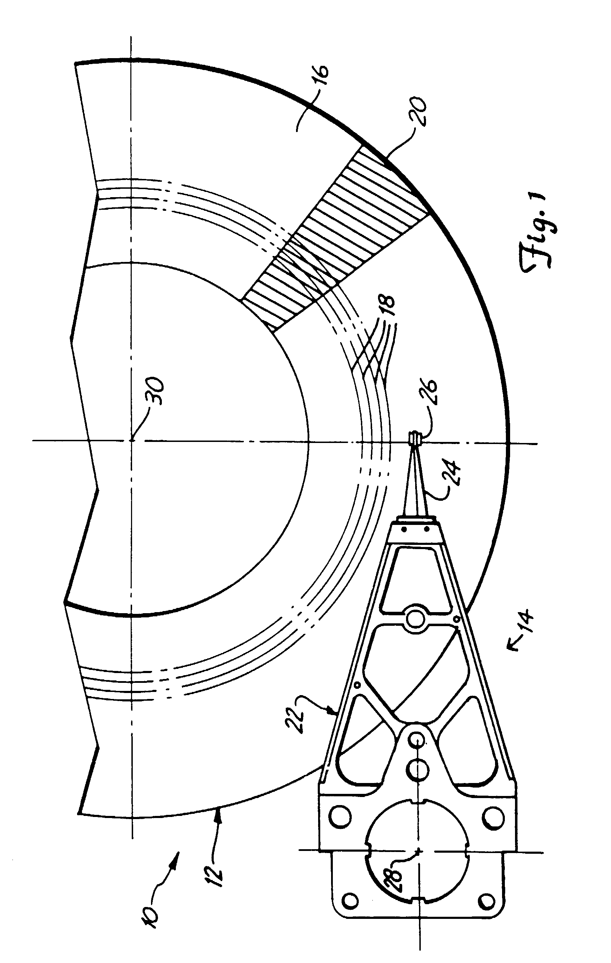

Figure 1 is a top plan view of a magnetic storage system 10 including a magnetic storage disk 12 and an arm 14.

The magnetic storage disk 12 includes a surface 16 divided into data tracks 18 and data sectors 20. The data tracks 18 extend radially around the surface 16 and the data sectors 20 extend axially from a centre of rotation 30 of the magnetic storage disk 12.

The arm 14 includes a support arm 22 and a flexure arm 24. The flexure arm 24 carries a slider 26 at its distal end. The slider 26 carries a magneto-resistive sensor (not shown in Figure 1).

The arm 14 rotates about an axis of rotation 28 so that the slider 26 moves radially across the surface of the disk 12. As the magnetic disk 12 rotates about the axis 30, the slider 26 "flies" slightly above the surface 16. By rotating the arm 14 about the axis 28, the slider 26 moves between adjacent tracks 18 above the surface 16.

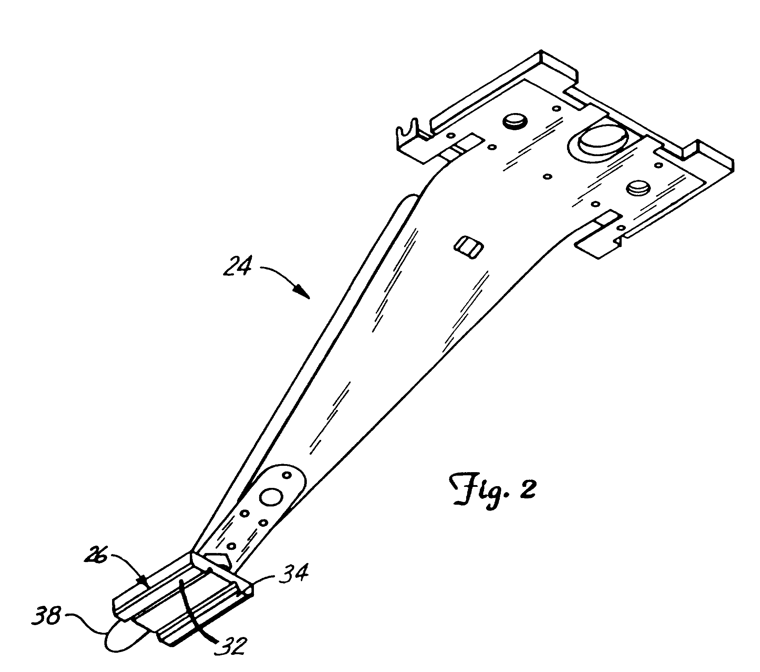

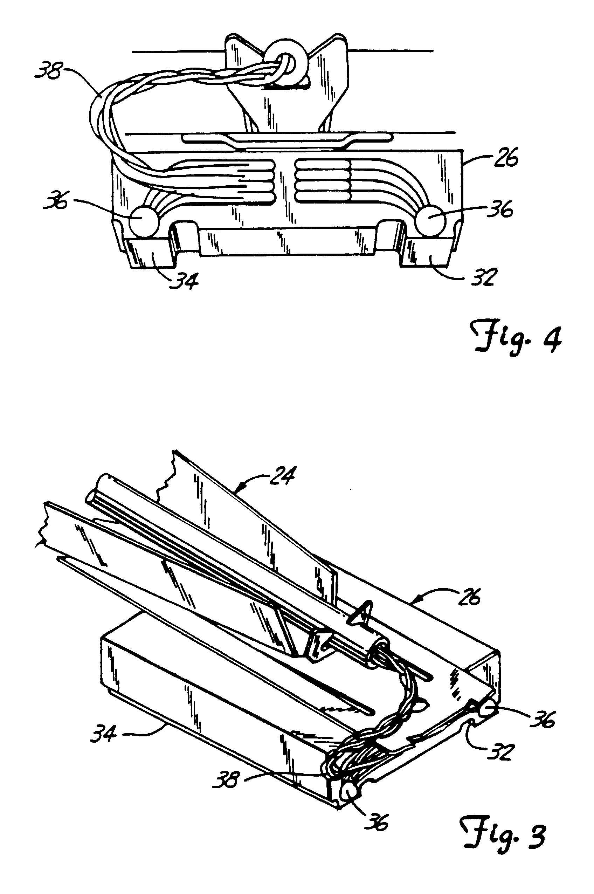

Figure 2 is a perspective view of the flexure arm 24 and the slider 26. The slider 26 includes rails 32, 34 which contribute to the aero-dynamic properties of the slider. The slider 26 also carries magneto-resistive heads 36 (see Figure 3). Magneto-resistive heads 36 are connected to electrical conductors 38.

Figures 3 and 4 are perspective views of the slider 26. The magneto-resistive heads 36 include four electrical connections, two of which are used for a write coil and two of which are used for read back of magnetically stored information.

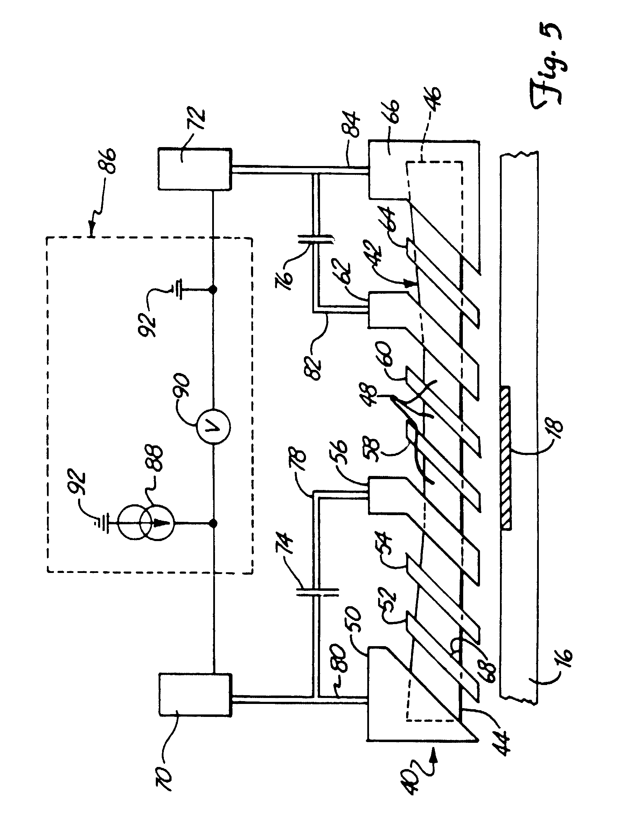

Figure 5 shows a magneto-resistive sensor 40 according to the present invention. The magneto-resistive sensor 40 comprises a portion of magneto-resistive head 36 and includes a magneto-resistive element 42. The magneto-resistive sensor 40 is shown relative to a data track 18 of the surface 16. The magneto-resistive element 42 includes a first end 44, a second end 46 and a central active region 48. Equipotential strips 50, 52, 54, 56, 58, 60, 62, 64, 66 are positioned along the length of the magneto-resistive element 42. The strips 50 to 66 are positioned at an angle 68 with respect to the length direction of the magneto-resistive element 42. The magneto-resistive sensor 40 includes terminals 70, 72 and capacitors 74, 76. The capacitor 74 is connected to the strip 56 through an electrical conductor 78, and to the strip 50 through an electrical conductor 80. The capacitor 76 is connected to the strip 62 through an electrical conductor 82 and to the strip 66 through an electrical conductor 84. The terminals 70, 72 are connected to the strips 50, 56, respectively.

Data sense circuitry 86 connects to the terminals 70, 72 of the magneto-resistive sensor 40. The data sense circuitry 86 includes a current source 88 and a voltage sensor 90. The current source 88 is electrically connected between the terminals 70 and electrical ground 92. The voltage sensor 90 is electrically connected to the terminal 70 and the terminal 72 and electrical ground 92. The voltage sensor 90 is connected to measure the voltage difference between the terminals 70, 72 of the magneto-resistive sensor 40.

The current source 88 drives current through the magneto-resistive element 42 from the strip 50 towards the strip 66. This current will leave and enter each strip 50 to 66 in a direction normal to the edge of the magneto-resistive element.

The capacitors 74, 76 block DC current from the current source 88. Thus, DC current enters the magneto-resistive sensor 40 through the strip 50 and exits the magneto-resistive sensor 40 through the strip 66. The data track 18 carries magnetically encoded information. This information sets up a magnetic field in the central active region 48 of the magneto-resistive sensor 40. As the magneto-resistive sensor 40 moves across the surface 16, the magnetic fields through the active region 48 changes. The changing magnetic field alters the resistance of the active region 48 of the magneto-resistive sensor 40, which changes the voltage drop across the active region. This causes a changing voltage drop between the strip 56 and the strip 62. The changing voltage drops sets up an AC signal between the strips 56, 62. The capacitors 74, 76 lock the DC sense current provided by the current source 88 but allow the AC signal from the strips 56, 62 to pass. The voltage sensor 90 connected between the terminals 70, 72 detects the AC signal between the strips 56, 62. This data signal is representative of magnetically encoded information recorded upon the data track 18 of the surface 16.

In the preferred embodiment of the present invention shown in Figure 5, the capacitors 74, 76 are manufactured directly upon a wafer which carries the magneto-resistive sensor 40. The electrical conductors 78 to 84 are also fabricated directly upon the wafer. The terminals 70, 72 provide bonding pads to allow connection to the magneto-resistive sensor 40. The sense current from the current source 88 is allowed to pass through the entire "barber pole" of the magneto-resistive sensor 40 to achieve maximum benefits provided by the "hammer head" design to eliminate Barkhausen noise. The capacitors 74, 76 reduce the active region in which magnetically encoded data is sensed, so that spurious signals picked up by the "wing" portions (the two areas on each side of the active region 48) do not contribute to the AC voltage signal sensed by the voltage sensor 90. Signals picked up by the wing portions of the magneto-resistive sensor 40 cause resistance variations between the strips 50 and 56 or the strips 60 and 66. However, any AC signal generated due to these resistance variations are electrically shorted by the capacitors 74, 76.

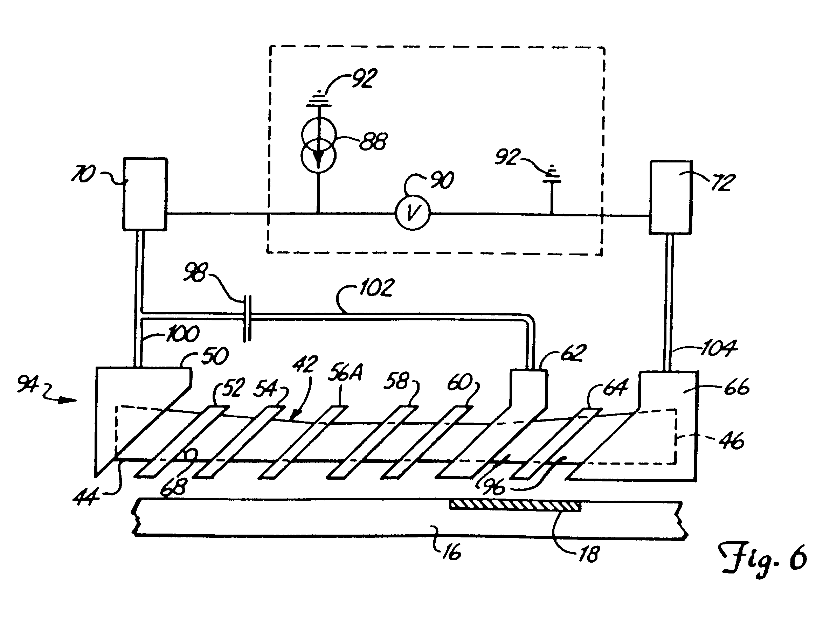

Figure 6 shows another embodiment of a magneto-resistive sensor 94 according to the present invention. Like parts in Figures 5 and 6 have been designated by the same reference numerals and only the differences between the embodiments will be described in detail. In Figure 6, an active region 96 of the magneto-resistive element 42 is positioned over the data track 18 of the surface 16. A blocking capacitor 98 is connected between the strip 50 and the strip 62. The capacitor 98 connects to the strip 50 through a conductor 100 and to the strip 62 through a conductor 102. The strip 66 connects to the terminal 72 through an electrical conductor 104.

In the magneto-resistive sensor 94, the active region 96 has been moved toward the second end 46 of the magneto-resistive element 42. Using this configuration, a single blocking capacitor 98 can be used. The current source 88 drives a sense current through the entire length of the magneto-resistive element 42, between the strip 50 and the strip 66. The capacitor 98 electrically shorts any AC signals which develop between the strip 50 and the strip 62. However, the capacitor 98 allows any AC signal developed between the strip 62 and the strip 66 to pass to the terminal 70. The voltage sensor 90, connected between the terminal 70 and the terminal 72 detects any AC signal developed between them which carry AC signals developed between the strips 62, 66. The capacitor 98 prevents DC current from flowing along the conductor 102 into the strip 62.

The capacitor 98 and electrical conductors 100, 102, 104 are preferably fabricated directly upon a wafer which carries the magneto-resistive sensor 94. The magneto-resistive sensor 94 shown in Figure 6, exhibits the benefit of the barber pole and only requires two terminals.

In selecting capacitors, larger sized capacitors provide greater attenuation to the off track AC data read back signal. The capacitors provide a one pole filter. In selecting the size of the capacitors, the frequency of the data signal must be considered. Typically 0.1 micro-Farad capacitors should be sufficient.

The present invention provides a "hammer head" design magneto-resistive sensor which uses a barber pole element to reduce Barkhausen noise and which requires only two electrical connections to operate. Blocking capacitors are used to develop two different signal paths, one for the DC sense current which passes through the entire length of the barber pole element, and one for the AC data signal which originates in the active region of the magneto-resistive element. The blocking capacitors are fabricated directly upon the wafer which is used to carry the magneto-resistive sensor. Because only two terminals are used in magneto-resistive sensors according to the present invention, it provides magneto-resistive sensors which are easier to manufacture and offer improved reliability.

Although the illustrated embodiments of the present invention are "hammer head" design magneto-resistive sensors which use barber pole magneto-resistive elements, the present invention is applicable to any magneto-resistive head design where it is desirable to reduce the number of terminals needed to operate the magneto-resistive sensor. Additionally, although capacitors have been shown, any type of filtering circuit or device may be used.

## Claims

1. A magneto-resistive sensor comprising: an elongated magneto-resistive element (42) having an active region (48; 96) for sensing information stored upon a magnetic storage medium (12) and having a first wing region; first and second terminals (70, 72) applied to opposite ends (44, 46) of the magneto-resistive element (42); characterised by first means (74, 76; 98) connected to the magneto-resistive element (42) for electrically shorting out AC signals generated by the first wing region of the magneto-resistive element (42).

2. A magneto-resistive sensor as claimed in claim 1, characterised by a plurality of electrically conductive strips (50 to 66) applied to the magneto-resistive element (42) and spaced between the first and second ends (44, 46).

3. A magneto-resistive sensor as claimed in claim 2, characterised in that the said first means is a capacitor (74; 98) connected between a first conductive strip (76; 62) and the first terminal (70; 72).

4. A magneto-resistive sensor as claimed in any preceding claim, characterised in that the magneto-resistive element (42) has a second wing region, the active region (48) being disposed between the first and second wing regions, and by second means (76) connected to the magneto-resistive element (42) for electrically shorting out AC signals generated by the second wing region of the magneto-resistive element.

5. A magneto-resistive sensor as claimed in Claim 4 when dependent upon claim 3, characterised in that said second means is a capacitor (76) connected between the second conductive strip (62) and the second terminal (72), the second conductive strip (62) being further spaced from the first end (44) of the magneto-resistive element than the first conductive strip (56).

6. A magneto-resistive sensor according to claim 1, wherein a third terminal is applied between the first and second terminals (70, 72) to the elongated magneto-resistive element (42); and means connected to the magneto-resistive element defines an AC signal path through the active region of the magneto-resistive element (42).

7. An apparatus for receiving a magnetically encoded signal comprising a magneto-resistive sensor according to any of the preceding claims, wherein means connected to first and second terminals of the sensor is provided for sensing an AC signal generated in less than the entire length of the magneto-resistive element.

8. A magnetic storage system including a magneto-resistive sensor according to any of the preceding claims.

## Patentansprüche

1. Magnetoresistiver Sensor mit: einem langgestreckten magnetoresistiven Element (42), das einen aktiven Bereich (48,96) zur Messung von auf einem magnetischen Speichermedium (12) gespeicherter Information und einen ersten Flügelbereich aufweist; und ersten und zweiten Anschlüssen (70,72), die auf gegenüberliegende Enden (44,46) des magnetoresistiven Elementes (42) aufgebracht sind,
gekennzeichnet durch eine erste Einrichtung (74,76;98), die mit dem magnetoresistiven Element (42) verbunden ist, um elektrisch Wechselspannungssignale, die von dem ersten Flügelbereich des magnetoresistiven Elementes (42) erzeugt werden, kurzzuschließen.

2. Magnetoresistiver Sensor nach Anspruch 1,
gekennzeichnet durch eine Vielzahl von elektrisch leitenden Streifen (50-66), die auf das magnetoresistive Element (42) aufgebracht und mit Abstand zwischen den ersten und zweiten Enden (44,46) angeordnet sind.

3. Magnetoresistiver Sensor nach Anspruch 2,
dadurch gekennzeichnet, daß die erste Einrichtung ein Kondensator (74;98) ist, der zwischen einem ersten leitenden Streifen (76;62) und dem ersten Anschluß (70;72) angeschaltet ist.

4. Magnetoresistiver Sensor nach einem der vorhergehenden Ansprüche,
dadurch gekennzeichnet, daß das magnetoresistive Element (42) einen zweiten Flügelbereich aufweist, daß der aktive Bereich (48) zwischen den ersten und zweiten Flügelbereichen angeordnet ist, und daß eine zweite Einrichtung (76) mit dem magnetoresistiven Element (42) verbunden ist, um von dem zweiten Flügelbereich des magnetoresistiven Elementes erzeugte Wechselspannungssignale elektrisch kurzzuschließen.

5. Magnetoresistiver Sensor nach Anspruch 4 unter Rückbeziehung auf Anspruch 3,
dadurch gekennzeichnet, daß die zweite Einrichtung ein Kondensator (76) ist, der zwischen dem zweiten leitenden Streifen (62) und dem zweiten Anschluß (72) angeschlossen ist, und daß der zweite leitende Streifen (62) in großerem Abstand von dem ersten Ende (44) des magnetoresistiven Elementes angeordnet ist, als der erste leitende Streifen (56).

6. Magnetoresistiver Sensor nach Anspruch 1, bei dem ein dritter Anschluß zwischen den ersten und zweiten Anschlüssen (70,72) an dem langgestreckten magnetoresistiven Element (42) angebracht ist, wobei die mit dem magnetoresistiven Element verbundene Einrichtung einen Wechselspannungs-Signalpfad durch den aktiven Bereich des magnetoresistiven Elementes (42) bildet.

7. Vorrichtung zum Empfang eines magnetisch codierten Signals, mit einem magnetoresistiven Sensor gemäß einem der vorhergehenden Ansprüche, wobei mit den ersten und zweiten Anschlüssen des Sensors verbundene Einrichtungen zur Messung eines Wechsel;spannungssignals vorgesehen sind, das in weniger als der gesamten Länge des magnetoresistiven Elementes erzeugt wird.

8. Magnetisches Speichersystem, das einen magnetoresistiven Sensor gemäß einem der vorhergehenden Ansprüche einschließt.

## Revendications

1. Détecteur magnétorésistif comprenant : un élément magnétorésistif allongé (42) ayant une zone active (48 ; 96) pour détecter des informations stockées sur un support de stockage magnétique (12) et ayant une première aile latérale ; des première et deuxième bornes (70, 72) appliquées aux extrémités opposées (44, 46) de l'élément magnétorésistif (42) ; caractérisé par des premiers moyens (74, 76 ; 98) reliés à l'élément magnétorésistif (42) pour court-circuiter électriquement des signaux de courant alternatif générés par la première aile latérale de l'élément magnétorésistif (42).

2. Détecteur magnétorésistif selon la revendication 1, caractérisé par une pluralité de bandes (50 à 66) électriquement conductrices appliquées à l'élément magnétorésistif (42) et espacées entre les première et seconde extrémités (44, 46).

3. Détecteur magnétorésistif selon la revendication 2, caractérisé en ce que lesdits premiers moyens sont constitués par un condensateur (74 ; 98) relié entre une première bande conductrice (56 ; 62) et la première borne (70 ; 72).

4. Détecteur magnétorésisitif selon l'une quelconque des revendications précédentes, caractérisé en ce que l'élément magnétorésistif (42) possède une seconde aile latérale, la aile active (48) étant disposée entre les première et seconde ailes latérales, et par des seconds moyens (76) reliés à l'élément magnétorésistif (42) pour court-circuiter électriquement des signaux de courant alternatif générés par la seconde aile latérale de l'élément magnétorésistif.

5. Détecteur magnétorésistif selon la revendication 4 dépendant de la revendication 3, caractérisé en ce que lesdits seconds moyens sont constitués par un condensateur (76) relié entre la seconde bande conductrice (62) et la deuxième borne (72), la seconde bande conductrice (62) étant plus espacée de la première extrémité (44) de l'élément magnétorésistif que la première bande conductrice (56).

6. Détecteur magnétorésistif selon la revendication 1, dans lequel une troisième borne est appliquée entre les première et deuxième bornes (70, 72) à l'élément magnétorésistif allongé (42) ; et des moyens reliés à l'élément magnétorésistif définissent un chemin de signal de courant alternatif dans la zone active de l'élément magnétorésistif (42).

7. Dispositif destiné à recevoir un signal magnétiquement codé comprenant un détecteur magnétorésistif selon l'une quelconque des revendications précédentes, dans lequel les moyens reliés aux première et deuxième bornes du détecteur sont prévus pour détecter un signal de courant alternatif généré dans moins de la longueur totale de l'élément magnétorésistif.

8. Système de stockage magnétique comprenant un détecteur magnétorésistif selon l'une quelconque des revendications précédentes.
